# FASCICULE DE BREVET EUROPEEN

(11) **EP 0 608 165 B1**
(45) Date de publication et mention de la délivrance du brevet: **23.10.1996**
(21) Numéro de dépôt: 94400095.9
(22) Date de dépôt: 14.01.1994
(51) Int. Cl.: H01S 3/085, H04B 10/18, H01S 3/103

(54) **Source semi-conductrice d'impulsions optiques à commutation de gain et système de transmission à solitons**
Halbleiter-Quelle optischer Pulse mit Schalten der Verstärkung und Solitonenübertragungssystem
Semi-conductor optical pulse source using gain switching and a soliton transmission system

(30) Priorité: 19.01.1993 FR 9300473
(43) Date de publication de la demande: 27.07.1994
(73) Titulaire: ALCATEL N.V., NL-1077 XX Amsterdam (NL)
(72) Inventeur: Brun, Elisabeth, F-75005 Paris (FR); Chesnoy, Jose, F-74014 Paris (FR); Hamaide, Jean-Pierre, F-91180 St Germain Les Arpajon (FR); Lesterlin, Dominique, F-75007 Paris (FR)
(74) Mandataire: Bourely, Paul

(56) Documents cités:
- EP-A- 0 314 490
- ELECTRONICS LETTERS., vol.16, no.12, 5 Juin 1980, STEVENAGE, HERTS, GB pages 456 - 457 Y. SAKAKIBARA 'single-mode oscillation under high-speed direct modulation in GaInAsP/InP integrated twin-guide lasers with distributed Bragg'
- PATENT ABSTRACTS OF JAPAN vol. 13, no. 132 (E-736) 31 Mars 1989 & JP-A-63 299 291 (KOKUSAI DENSHIN DENWA CO LTD)
- ELECTRONICS LETTERS., vol.27, no.3, 31 Janvier 1991, STEVENAGE, HERTS, GB pages 222 - 224 D.M: SPIRIT ET AL 'Nonlinear, dispersion free 10GHz optical pulse train transmission in distributed erbium dopde fibre'
- EFOC/LAN 1992, THE TENTH ANNUAL EUROPEAN OPTICAL COMMUNICATIONS AND NETWORKS CONFERENCE, PARIS, FRANCE JUNE 24-26, 1992 pages 273 - 275 J. M. LOURTIOZ ET AL 'Transform limited gain-switched DFB lasers pulses for long haul soliton transmission'

## Description

La présente invention concerne la formation d'impulsions optiques brèves, utilisables notamment pour une transmission d'information sur une fibre optique. On sait que l'action combinée des effets optiques dispersifs et non linéaires de type Kerr introduits par une telle fibre permet à des impulsions de forme convenable, appelées "solitons", de se propager sans déformation. C'est pourquoi l'utilisation de telles impulsions est envisagée dans les transmissions transocéaniques (6000 - 9000 km) à haut débit. Les grandes distances de transmission sont atteintes par la propagation des solitons dans des fibres dont les pertes sont compensées par des amplificateurs optiques à fibres dopées à l'erbium.

La transmission par solitons nécessite de disposer d'un train d'impulsions lumineuses brèves émises périodiquement. Par exemple, pour une transmission à 10 Gbit/s, les impulsions doivent mesurer environ 20 ps, (à mi intensité). De plus ces impulsions doivent être "proches de la limite de Fourier", c'est-à-dire qu'un produit critique, qui est le produit de leur durée par leur largeur spectrale, doit être inférieur à une limite d'environ 0,7 et s'approcher autant que possible d'une valeur optimale de 0,32.

Selon une première méthode connue on peut générer de telles impulsions par couplage de modes d'un laser semiconducteur à cavité externe. Cette méthode a été décrite par D.M. BIRD, R.M. FATAH, M.K. COX, P.D. CONSTANTINE.. Electronics Letters 26, p. 2086 (1990). Une deuxième méthode connue utilise la commutation du gain d'un laser à semi-conducteur monolithique et a été décrite par un document DOWNEY:
L.M. DOWNEY, J.F. BOWERS, R.S. TUCKER and E. AGYEKUM IEEE, J. Quant. Elec. QE 23, 1039 (1987).

La première méthode nécessite un laser complexe dont l'utilisation est délicate. Elle-est donc difficilement envisageable sur le terrain.

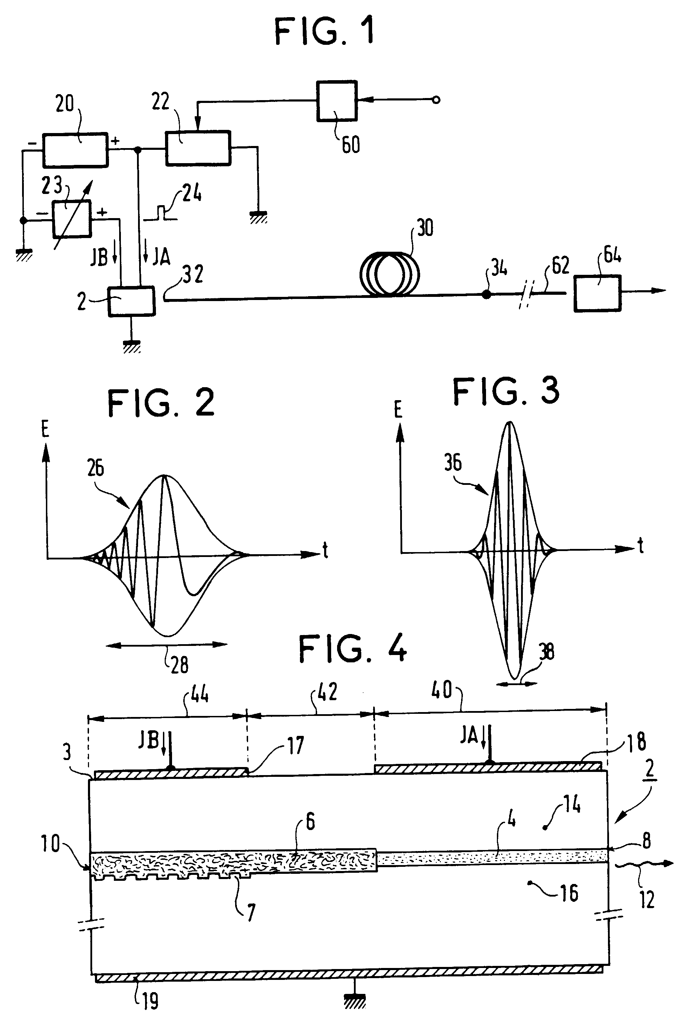

La seconde méthode permet d'émettre des impulsions qui présentent une grande largeur spectrale qui les laisse très éloignées de la limite de Fourier. Cette largeur spectrale résulte du fait que la commutation de gain du laser est obtenue par l'injection d'un courant fortement variable. La fréquence optique varie alors fortement au cours de chacune des impulsions produites en raison du fait que l'indice de réfraction du matériau de la cavité laser dépend du courant. Cette variation de l'indice de réfraction se traduit par une variation correspondante de la longueur optique de la cavité laser, et donc de la fréquence optique de résonance de la cavité au cours de l'impulsion délivrée. Il en résulte une impulsion dont le flanc montant est formé par une onde de fréquence optique plus élevée que le flanc descendant (figure 2).

Cette variation de fréquence peut être utilisée pour diminuer la durée de l'impulsion par un procédé connu appelé "compression". Selon ce procédé l'impulsion traverse un milieu optique dont le chemin optique dépend de la fréquence optique. En particulier, une fibre spéciale à dispersion fortement décalée (dont la longueur d'onde annulant la dispersion est plus élevée que la longueur d'onde centrale de l'impulsion émise par le laser) présente un chemin optique plus long pour les fréquences élevées que pour les fréquences basses.

Elle permet ainsi de retarder le flanc montant par rapport au flanc descendant: En ajustant la longueur de cette fibre on forme une impulsion dont la durée corrigée est beaucoup plus faible que la durée initiale et dont le produit critique se rapproche donc de la valeur théorique recherchée.

En particulier, un laser DFB connu délivre des impulsions dont une compression amène le produit critique au voisinage de 0,75.

La présente invention a notamment pour buts de réaliser de manière simple d'abord une plaquette semi-conductrice délivrant des impulsions optiques brutes de largeur spectrale diminuée, ensuite une source comportant cette plaquette et une ligne dispersive délivrant des impulsions optiques comprimées de largeur spectrale diminuée aptes à constituer des solitons.

Une source semi-conductrice d'impulsions optiques selon l'invention est définie dans la revendication 1 dont le préambule correspond audit document DOWNEY. La revendication 8 se réfère à un système de transmission à solitons comprenant une telle source.

La section supplémentaire insère sa propre longueur optique dans celle de la cavité résonante et réduit ainsi la variation relative de cette dernière longueur et donc celle de la fréquence optique des impulsions optiques à leur sortie de la plaquette, c'est-à-dire qu'elle réduit la largeur spectrale de ces impulsions. Cette réduction de la largeur spectrale des impulsions optiques est conservée après une compression optimale.

A l'aide des figures schématiques ci-jointes, on va décrire ci-après comment la présente invention peut être mise en oeuvre. Lorsqu'un même élément est représenté sur plusieurs figures il y est désigné par le même signe de référence.

La figure 1 représente une vue d'ensemble d'une source et d'un système de transmission selon la présente invention.

Les figures 2 et 3 représentent des diagrammes de variation du champ électrique d'impulsions optiques, respectivement en sortie d'une plaquette semi-conductrice et d'une ligne dispersive de cette source.

La figure 4 représente une vue en coupe de cette plaquette semi-conductrice.

On va d'abord décrire de manière générale, en se référant à ces figures, des dispositions communes à ladite source selon la présente invention et à une source connue par ledit document DOWNEY et par un document LOURTIOZ: J.M. LOURTIOZ, J.M. XIE,L. CHUSSEAU, J.L. BEYLAT, E.BRUN, J.P. HAMAIDE, F. POMMEREAU publié dans les proceedings EFOC'LAN 1992, p.273, 1992.

Conformément à ces dipositions communes une source comporte une plaquette semi-conductrice monolithique 2 s'étendant selon une direction longitudinale et comportant elle même les éléments suivants:
- Une structure guidante 4, 6 traversant cette plaquette selon une direction longitudinale pour guider une lumière selon cette direction. Cette structure comporte un matériau actif 4 tel qu'une injection de porteurs de types opposés dans ce matériau fasse apparaître un gain pour amplifier une lumière laser guidée par cette structure. Ce gain et l'indice de réfraction de ce matériau dépendent de la concentration de ces porteurs.
- Deux faces extrêmes 8, 10 de cette plaquette forment deux extrémités de cette structure guidante et présentent des réflectances pour constituer avec cette structure une cavité résonante pour une telle lumière laser. Cette cavité présente une longueur optique dépendant de l'indice de réfraction du matériau actif et elle possède une succession de fréquences de résonance inversement proportionnelles à cette longueur optique. La réflectance de l'une au moins des faces extrêmes 8 est limitée pour permettre à cette lumière laser 12 d'être émise à partir de cette cavité.
- Enfin des couches dopées 14 et 16 situées de part et d'autre du matériau actif 4 et aptes à fournir lesdits porteurs de types opposés.

Cette source comporte en outre les éléments suivants:
- Des électrodes 18, 19 situées sur la plaquette 2 pour permettre d'y faire circuler un courant d'alimentation JA provoquant ladite injection de porteurs de types opposés à partir des couches 14 et 16. Une telle injection provoque une croissance et une émission de la lumière laser dans et à partir de la cavité à au moins une fréquence de résonance de cette dernière.
- Un générateur d'alimentation 20, 22 fournissant le courant d'alimentation JA à ces électrodes. Ce générateur est choisi pour imposer à ce courant des variations formant des impulsions de courant 24 réalisant une commutation dudit gain. Cette commutation de gain est telle que la lumière laser 12 soit émise par la plaquette 2 sous la forme d'impulsions. Ces dernières constituent des impulsions optiques brutes 26 et elles présentent une durée initiale 28. La variation du courant d'alimentation JA formant chaque telle impulsion de courant provoque une variation parasite de l'indice de réfraction du matériau actif et donc une variation de la longueur optique de la cavité au cours de chacune de ces impulsions optiques. Cette variation de longueur est une variation absolue et s'accompagne d'une variation relative constituée par le rapport de cette variation absolue à cette longueur optique. Elle entraîne une variation absolue de la fréquence de la lumière laser et confére une largeur spectrale initiale à l'impulsion optique. Une variation relative de cette fréquence est constituée par le rapport de cette variation absolue à cette fréquence. Elle est égale à la variation relative de longueur optique.
- Enfin une ligne dispersive 30 propre à guider la lumière laser et à lui appliquer un retard dépendant de sa fréquence. Cette ligne a une entrée 32 pour recevoir les impulsions optiques brutes 26 et une sortie 34 pour fournir en réponse des impulsions optiques comprimées 36 présentant une durée corrigée 38. Elle présente à la longueur d'onde centrale des impulsions optiques une dispersion chromatique négative qui impose une vitesse de propagation plus petite aux composantes optiques de fréquences élevées qu'à celles de fréquences basses. Sa longueur est choisie pour que cette durée corrigée soit minimisée.

Selon la présente invention la plaquette 2 présente plusieurs sections successives selon la direction longitudinale. Dans une section de gain 40 la structure guidante 4, 6 comporte le matériau actif 4 et reçoit l'injection de porteurs provoquée par le courant d'alimentation. Il en résulte que la variation de ce courant entraîne la dite variation parasite de l'indice de réfraction de ce matériau. Dans au moins une section supplémentaire 42, 44 la structure guidante est agencée de manière qu'aucune variation sensible d'indice de réfraction n'y soit provoquée par la variation du courant d'alimentation, tout au moins dans le même sens que ladite variation parasite. La présence d'une telle section supplémentaire augmente la longueur optique de la cavité résonante et cette augmentation entraîne diverses diminutions: celle de la variation relative de longueur optique, donc celle de la variation relative de la fréquence de la lumière laser, donc celle de la variation absolue de cette fréquence, et donc finalement celle de la largeur spectrale des impulsions.

Plus particulièrement, la structure guidante comporte les éléments suivants.
- Un ruban actif 4 limité à la section de gain 40 et constitué par le matériau actif.- Ce matériau présente un indice de réfraction plus grand que celui des matériaux environnants.
- Un guide passif 6 s'étendant au moins dans les sections supplémentaires 42 et 44. Ce guide est constitué d'un matériau de guidage différent du matériau actif et présentant lui aussi un indice de réfraction plus grand que celui des matériaux environnants.

Grâce à la présence de ce guide passif une dite section supplémentaire peut constituer une section de réseau 44. Dans cette section le guide passif 6 présente une succession périodique de variations de ses dimensions transversales, cette succession constituant un réflecteur de Bragg 7. Ce réflecteur sélectionne une fréquence de résonance de la cavité optique pour constituer la fréquence de la lumière laser 12 émise par la plaquette.

De préférence une face supérieure 3 de la plaquette 2 porte d'une part une électrode de gain 18 localisée dans la section de gain 40 et alimentée par le générateur d'alimentation 20, 22, d'autre part une électrode de réglage de fréquence 17 localisée dans une section de réglage de fréquence 44. Cette dernière électrode est connectée à un générateur de réglage de fréquence 23 pour faire traverser le guide passif 6 par un courant de réglage de fréquence JB entraînant une injection de porteurs de charges de types opposés dans le matériau de guidage. Ce courant commande ainsi l'indice de réfraction de ce matériau et donc la fréquence de résonance sélectionnée par le réflecteur de Bragg 7.

La plaquette 2 comporte en outre une section passive 42 constituant une autre section supplémentaire.

Typiquement la plaquette 2 est constituée d'un matériau binaire tel que le phosphure d'indium en dehors du ruban actif 4 et du guide passif 6. Ce matériau binaire est dopé de type n dans la couche 16. Il est dopé de type p dans la couche 14. Les matériaux actif et de guidage sont ternaires ou quaternaires et présentent des bandes interdites d'énergie de largeurs différentes.

La présente invention a également pour objet un système de transmission optique à solitons comportant les éléments suivants:
- Une source semi-conductrice d'impulsions optiques telle que précédemment décrite.
- Un circuit d'entrée 60 recevant une information à transmettre et commandant le générateur d'alimentation 20, 22 de cette source pour lui faire fournir une succession d'impulsions optiques. Les intervalles de temps entre les impulsions sont représentatifs de cette information.
- Une fibre de ligne 62 constituée par une fibre optique de grande longueur recevant ces impulsions optiques. Cette fibre présente d'une part une dispersion chromatique positive, d'autre part un effet Kerr tels que cette dispersion et cet effet Kerr se compensent mutuellement pour conserver la forme d'une impulsion optique lorsque cette impulsion présente une intensité, une durée et une largeur spectrale aptes à constituer un soliton de cette fibre. La source d'impulsions optiques de ce système fournit de tels solitons.
- Enfin un récepteur 64 recevant les impulsions optiques transmises par la fibre de ligne 62. Ce récepteur traite ces impulsions pour restituer l'information qui était à transmettre.

## Revendications

1. Source semi-conductrice d'impulsions optiques comportant une plaquette semi-conductrice (2) dans laquelle une structure guidante longitudinale (4, 6) présente une longueur optique entre deux faces (8, 10) de cette plaquette, ces deux faces présentant des réflectances pour constituer une cavité résonante selon cette longueur pour une lumière laser, cette cavité contenant un matériau actif (4) pour que cette plaquette amplifie et émette une telle lumière laser à une fréquence commandée par cette longueur, cette source comportant en outre un générateur d'alimentation électrique (20, 22) réalisant une commutation du gain de cette plaquette pour lui faire émettre cette lumière sous la forme d'impulsions optiques,
cette source étant caractérisée par le fait que ladite plaquette (2) comporte longitudinalement non seulement une section de gain (40) dans laquelle ladite commutation de gain est réalisée et s'accompagne de variations parasites d'indice de réfraction, mais aussi au moins une section supplémentaire (42, 44) exemptée desdites variations parasites d'indice de réfraction, de manière à limiter la largeur spectrale desdites impulsions optiques.

2. Source selon la revendication 1, cette source comportant une plaquette semi-conductrice monolithique (2) s'étendant selon une direction longitudinale et comportant elle même:
- une structure guidante (4, 6) traversant cette plaquette selon ladite direction longitudinale pour guider une lumière selon cette direction, cette structure comportant un matériau actif (4) tel qu'une injection de porteurs de types opposés dans ce matériau fasse apparaître un gain pour amplifier une lumière laser guidée par cette structure, ce gain et l'indice de réfraction de ce matériau dépendant de concentrations de ces porteurs,
- deux faces extrêmes (8, 10) formant deux extrémités de ladite structure guidante et présentant des réflectances pour constituer avec cette structure une cavité résonante pour une dite lumière laser, cette cavité ayant une longueur optique dépendant dudit indice de réfraction dudit matériau actif, cette cavité ayant une succession de fréquences de résonance inversement proportionnelles à cette longueur optique, ladite réflectance de l'une au moins desdites faces extrêmes (8) étant limitée pour permettre à une dite lumière laser (12) d'être émise à partir de cette cavité,
- et des couches dopées (14, 16) situées de part et d'autre dudit matériau actif (4) et aptes à fournir lesdits porteurs de types opposés,
- ladite source comportant en outre:
- des électrodes (18, 19) situées sur ladite plaquette (2) pour permettre d'y faire circuler un courant d'alimentation (JA) provoquant ladite injection de porteurs de types opposés à partir desdites couches dopées, de manière à provoquer une croissance et une émission d'une dite lumière laser dans et à partir de ladite cavité à une dite fréquence de résonance de cette cavité,
- un générateur d'alimentation (20, 22) fournissant un dit courant d'alimentation (JA) à ces électrodes et imposant à ce courant des variations formant des impulsions de courant (24) réalisant une commutation dudit gain pour que ladite lumière laser (12) soit émise par ladite plaquette sous la forme d'impulsions optiques brutes (26) présentant une durée initiale (28), de sorte que la variation dudit courant d'alimentation (JA) dans chaque dite impulsion de courant provoque une variation de la longueur optique de ladite cavité au cours de chacune desdites impulsions optiques brutes, cette variation de cette longueur étant une variation absolue et s'accompagnant d'une variation relative constituée par le rapport de cette variation absolue à cette longueur optique, ces variations de longueur optique entraînant une variation absolue de fréquence de ladite lumière laser et conférant une largeur spectrale initiale à cette impulsion optique, une variation relative de cette fréquence étant constituée par le rapport de cette variation absolue à cette fréquence et étant égale à ladite variation relative de longueur optique,
- et une ligne dispersive (30) propre à guider ladite lumière laser et à lui appliquer un retard dépendant de sa fréquence, cette ligne ayant une entrée (32) pour recevoir lesdites impulsions optiques brutes (26) et une sortie (34) pour fournir en réponse des impulsions optiques comprimées (36) présentant une durée corrigée (38) inférieure à ladite durée initiale,
cette source étant caractérisée par le fait que ladite plaquette (2) présente successivement selon ladite direction longitudinale non seulement une section de gain (40) dans laquelle ladite structure guidante (4, 6) comporte ledit matériau actif (4) et reçoit ladite injection de porteurs provoquée par ledit courant d'alimentation de sorte que la variation de ce courant entraîne une variation parasite de l'indice de réfraction de ce matériau, mais aussi au moins une section supplémentaire (42, 44) dans laquelle cette structure guidante est agencée de manière qu'aucune variation sensible d'indice de réfraction n'y soit provoquée par ladite variation du courant d'alimentation dans le même sens que ladite variation parasite d'indice de réfraction, grâce à quoi la longueur optique de ladite cavité est augmentée et cette augmentation entraîne une diminution de la dite variation relative de cette longueur optique, une diminution de ladite variation relative de la fréquence de ladite lumière laser, une diminution de ladite variation absolue de cette fréquence, et finalement une diminution de ladite largeur spectrale.

3. Source selon la revendication 2, ladite structure guidante comportant:
- un ruban actif (4) limité à ladite section de gain (40) et constitué par ledit matériau actif, ce matériau présentant un indice de réfraction plus grand que celui de matériaux environnants,
- et un guide passif (6) s'étendant au moins dans ladite section supplémentaire (42, 44), ce guide étant constitué d'un matériau de guidage présentant un indice de réfraction plus grand que celui des matériaux environnants.

4. Source selon la revendication 3, caractérisée par le fait qu'une dite section supplémentaire constitue une section de réseau (44) dans laquelle ledit guide passif (6) présente une succession périodique de variations de ses dimensions transversales, cette succession constituant un réflecteur de Bragg (7) propre à sélectionner une dite fréquence de résonance de ladite cavité optique pour constituer la fréquence de ladite lumière laser (12).

5. Source selon la revendication 4, caractérisée par le fait qu'une face supérieure (3) de ladite plaquette (2) porte d'une part une dite électrode constituant une électrode de gain (18) localisée dans ladite section de gain (40) et alimentée par ledit générateur d'alimentation (20, 22), d'autre part une électrode de réglage de fréquence (17) localisée dans ladite section de réglage de fréquence (44) et connectée à un générateur de réglage de fréquence (23) de ladite source pour faire traverser ledit guide passif (6) par un courant de réglage de fréquence (JB) entraînant une injection de porteurs de charges de types opposés dans ledit matériau de guidage, de manière à commander l'indice de réfraction de ce matériau et la fréquence de résonance sélectionnée par ledit réflecteur de Bragg (7).

6. Source selon la revendication 4, caractérisée par le fait que ladite plaquette (2) comporte en outre une section passive (42) constituant une dite section supplémentaire.

7. Source selon la revendication 3, ladite plaquette (2) étant constituée d'un matériau binaire en dehors des dits ruban actif (4) et guide passif (6), ce matériau étant dopé de type n dans une couche (16) s'étendant sous ladite structure guidante (4, 6), et étant dopé de type p dans une couche (14) s'étendant au-dessus de cette structure guidante, lesdits matériaux actif et de guidage étant ternaires ou quaternaires et présentant des bandes interdites d'énergie de largeurs-différentes.

8. Système de transmission optique à solitons comportant
- une source semi-conductrice d'impulsions optiques pour fournir sur commande des impulsions optiques (36),
- un circuit d'entrée (60) recevant une information à transmettre et commandant un générateur d'alimentation (20, 22) de cette source pour lui faire fournir une succession d'impulsions optiques dans laquelle les intervalles de temps entre les impulsions sont représentatifs de l'information à transmettre,
- une fibre de ligne (62) constituée par une fibre optique de grande longueur recevant ladite succession d'impulsions optiques et présentant d'une part une dispersion chromatique, d'autre part un effet Kerr tels que cette dispersion et cet effet Kerr se compensent mutuellement pour conserver la forme d'une impulsion optique lorsque cette impulsion présente une intensité, une durée et une largeur spectrale caractéristiques d'un soliton de cette fibre,
- et un récepteur (64) recevant les impulsions optiques transmises par ladite fibre de ligne et traitant ces impulsions reçues pour restituer ladite information à transmettre,
ce système étant caractérisé par le fait que ladite source d'impulsions optiques est une source selon l'une quelconque des revendications 1, 2, 5 et 7 de manière qu'elle fournisse lesdites impulsions optiques sous la forme de dits solitons de ladite fibre de ligne (62).

## Patentansprüche

1. Halbleiterquelle für optische Impulse, die ein Halbleiterplättchen (2) aufweist, in dem eine Führungsstruktur (4, 6) in Längsrichtung eine optische Länge zwischen zwei Seiten (8, 10) dieses Plättchens aufweist, wobei diese beiden Seiten reflektierend sind, um einen Resonanzhohlraum gemäß dieser Länge für ein Laserlicht zu bilden, wobei dieser Hohlraum ein aktives Material (4) aufweist, damit dieses Plättchen ein solches Laserlicht bei einer von dieser Länge gesteuerten Frequenz verstärkt und aussendet, wobei diese Quelle außerdem einen elektrischen Speisegenerator (20, 22) aufweist, der eine Umschaltung des Verstärkungsgrads dieses Plättchens durchführt, um es dieses Licht in Form von Lichtimpulsen aussenden zu lassen,
dadurch gekennzeichnet, daß das Plättchen (2) in Längsrichtung nicht nur einen Verstärkungsabschnitt (40), in dem die Verstärkungsgradumschaltung durchgeführt wird, die von parasitären Veränderungen des Brechungsindex begleitet wird, sondern auch mindestens einen zusätzlichen Abschnitt (42, 44) aufweist, der diese parasitären Brechungsindexveränderungen nicht aufweist, um die Spektralbreite der optischen Impulse zu begrenzen.

2. Quelle nach Anspruch 1, die ein monolithisches Halbleiterplättchen (2) aufweist, das sich in einer Längsrichtung erstreckt und selbst enthält:
- eine lichtführende Struktur (4, 6), die diese Plättchen in Längsrichtung durchquert, um ein Licht in dieser Richtung zu führen, wobei diese Struktur ein aktives Material (4) enthält, in dem eine Injektion von Ladungsträgern entgegengesetzter Art eine Verstärkung bewirkt, durch die ein von dieser Struktur geführtes Laserlicht verstärkt wird, wobei diese Verstärkung und der Brechungsindex dieses Materials von der Konzentration dieser Ladungsträger abhängen,
- zwei Endflächen (8, 10) dieses Plättchens, die zwei Enden dieser führenden Struktur bilden und reflektierend wirken, um mit dieser Struktur einen Resonanzhohlraum für ein solches Laserlicht zu bilden, wobei dieser Hohlraum eine optische Länge hat, die vom Brechungsindex des aktiven Materials abhängt, und eine Folge von Resonanzfrequenzen umgekehrt proportional zu dieser optischen Länge aufweist, wobei das Reflexionsvermögen mindestens einer der Endflächen (8) begrenzt ist, so daß ein Laserlicht (12) ausgehend von diesem Hohlraum ausgesendet werden kann,
- und dotierte Schichten (14, 16), die zu beiden Seiten des aktiven Materials (4) angeordnet sind und die Ladungsträger entgegengesetzter Arten liefern können,
- wobei diese Quelle außerdem enthält:
- Elektroden (18, 19), die sich auf dem Plättchen (2) befinden und einen Speisestrom (JA) durch das Plättchen fließen zu lassen, der die Injektion von Ladungsträgern entgegengesetzter Art ausgehend von den dotierten Schichten bewirkt, so daß ein Laserlicht in dem Hohlraum bei mindestens einer Resonanzfrequenz wächst und von ihm ausgesendet wird,
- einen Speisegenerator (20, 22), der einen Speisestrom (JA) an diese Elektroden liefert und diesem Strom Veränderungen aufprägt, die Stromimpulse (24) bilden, welche eine Umschaltung des Verstärkungsgrads bewirken, damit das Laserlicht (12) von dem Plättchen in Form von Rohlichtimpulsen (26) ausgesendet wird, die eine ursprüngliche Dauer (28) aufweisen, so daß die Veränderung des Speisestroms (JA) in jedem Stromimpuls eine Veränderung der optischen Länge des Hohlraums während jedes dieser Rohlichtimpulse bewirkt, wobei diese Längenveränderung eine absolute Veränderung ist und von einer relativen Veränderung begleitet wird, die aus dem Verhältnis dieser absoluten Veränderung und dieser optischen Länge besteht und eine absolute Veränderung der Frequenz des Laserlichts bewirkt und dem Lichtimpuls eine ursprüngliche Spektralbreite verleiht, wobei eine relative Veränderung dieser Frequenz aus dem Verhältnis dieser absoluten Veränderung zu dieser Frequenz besteht und der relativen Veränderung der optischen Länge gleicht,
- und eine Streuleitung (30), die das Laserlicht führen kann und es einer Verzögerung unterwirft, die von seiner Frequenz abhängt, wobei diese Leitung einen Eingang (32), der die Rohlichtimpulse (26) empfängt, und einen Ausgang (34) hat, der als Antwort komprimierte Lichtimpulse (36) liefert, die eine korrigierte Dauer (38) aufweisen, die geringer als die ursprüngliche Dauer ist,
dadurch gekennzeichnet, daß das Plättchen (2) nacheinander in Längsrichtung nicht nur einen Verstärkungsabschnitt (40), in dem die lichtführende Struktur (4, 6) das aktive Material (4) enthält und die Injektion von Ladungsträgern empfängt, die vom Speisestrom erzeugt wird, so daß die Veränderung dieses Stroms eine parasitäre Veränderung des Brechungsindex dieses Materials bewirkt, sondern auch mindestens einen zusätzlichen Abschnitt (42, 44) enthält, in dem die lichtführende Struktur so ausgebildet ist, daß keine wesentliche Veränderung des Brechungsindex hier durch die Veränderung des Speisestroms in der gleichen Richtung wie die parasitäre Veränderung des Brechungsindex erfolgt, so daß die optische Länge des Resonanzhohlraums vergrößert wird und diese Vergrößerung eine Verringerung der relativen Veränderung der optischen Länge, eine Verringerung der relativen Veränderung der Frequenz des Laserlichts, eine Verringerung der absoluten Veränderung dieser Frequenz und schließlich eine Verringerung der Spektralbreite der Impulse bewirkt.

3. Quelle nach Anspruch 2, deren lichtführende Struktur aufweist:
- ein auf den Verstärkungsabschnitt (40) begrenztes aktives Band (4), das vom aktiven Material gebildet wird und einen größeren Brechungsindex als die umgebenden Materialien hat,
- und einen passiven Lichtleiter (6), der sich mindestens in den zusätzlichen Abschnitten (42, 44) erstreckt und aus einem Lichtleitermaterial besteht, das einen größeren Brechungsindex als die umgebenden Materialien aufweist.

4. Quelle nach Anspruch 3, dadurch gekennzeichnet, daß ein zusätzlicher Abschnitt einen Netzabschnitt (44) bildet, in dem der passive Lichtleiter (6) eine periodische Folge von Veränderungen seiner Querabmessungen aufweist, die einen Bragg-Reflektor (7) bildet, welcher eine Resonanzfrequenz des optischen Hohlraums wählt, um die Frequenz des Laserlichts (12) zu definieren.

5. Quelle nach Anspruch 4, dadurch gekennzeichnet, daß eine Oberseite (3) des Plättchens (2) einerseits eine Verstärkungssteuerungselektrode (18), die sich im Verstärkungsabschnitt (40) befindet und vom Speisegenerator (20, 22) gespeist wird, und andererseits eine Frequenzeinstellelektrode (17) enthält, die sich in einem Frequenzeinstellabschnitt (44) befindet und mit einem Frequenzeinstellgenerator (23) der Quelle verbunden ist und einen Frequenzregelstrom (JB) durch den passiven Lichtleiter (6) fließen läßt, der eine Injektion von Ladungsträgern entgegengesetzter Arten in das Lichtleitermaterial bewirkt, um den Brechungsindex dieses Materials und somit die vom Bragg-Reflektor (7) ausgewählte Resonanzfrequenz zu steuern.

6. Quelle nach Anspruch 4, dadurch gekennzeichnet, daß das Plättchen (2) außerdem einen passiven Abschnitt (42) besitzt, der einen zusätzlichen Abschnitt bildet.

7. Quelle nach Anspruch 3, bei der das Plättchen (2) aus einem binären Material außerhalb des aktiven Bands (4) und des passiven Lichtleiters (6) besteht, wobei dieses binäre Material in einer Schicht (16) n-dotiert wird, die sich unter der Lichtleiterstruktur (4, 6) erstreckt, und in einer Schicht (14) p-dotiert ist, die sich oberhalb dieser Lichtleiterstruktur erstreckt, wobei die aktiven und Lichtleitermaterialien ternär oder quaternär sind und verbotene Energiebänder verschiedener Breiten besitzen.

8. Optisches Übertragungssystem mit Solitonen, das aufweist:
- eine Halbleiterquelle für optische Impulse, um auf Befehl optische Impulse (36) zu liefern,
- eine Eingangsschaltung (60), die eine zu übertragende Information empfängt und einen Speisegenerator (20, 22) dieser Quelle steuert, um ihn eine Folge von optischen Impulsen liefern zu lassen, in der die Zeitintervalle zwischen den Impulsen für die zu übertragende Information repräsentativ sind,
- eine Leitungsfaser (62) aus einer Lichtleitfaser großer Länge, die diese optischen Impulse empfängt und einerseits eine chromatische Streuung und andererseits einen Kerr-Effekt besitzt, so daß diese Streuung und dieser Kerr-Effekt sich gegenseitig kompensieren, um die Form eines optischen Impulses beizubehalten, wenn dieser Impuls eine Intensität, eine Dauer und eine Spektralbreite aufweist, die ein für Soliton dieser Faser charakteristisch sind,
- und einen Empfänger (64), der die von der Leitungsfaser (62) übertragenen optischen Impulse empfängt und diese empfangenen Impulse verarbeitet, um die Information wiederzugewinnen, die zu übertragen war,
dadurch gekennzeichnet, daß die Quelle optischer Impulse eine Quelle nach einem beliebigen der Ansprüche 1, 2, 5 und 7 ist, damit sie die optischen Impulse in Form von Solitonen der Leitungsfaser (62) liefert.

## Claims

1. A semiconductor light pulse source including a semiconductor chip (2) in which a longitudinal waveguide structure (4, 6) has an optical length between two faces (8, 10) of said chip, said two faces presenting reflectances to constitute a resonant cavity on said length for laser light, the cavity containing an active material (4) so that the chip amplifies and emits such laser light at a frequency controlled by said length;
the source further including an electrical power supply (20, 22) which gain switches the chip so as to make it emit said light in the form of light pulses;
the source being characterized by the fact that, along the length of said chip, the chip (2) includes not only a gain segment (40) in which said gain switching is performed and is accompanied by interfering variations in refractive index, but also at least one additional segment (42. 44) free from said interfering variations in refractive index, so as to limit the spectrum width of said light pulses.

2. A source according to claim 1, the source including a monolithic semiconductor chip (2) extending in a longitudinal direction and itself including:
a waveguide structure (4, 6) passing through the chip in said longitudinal direction to guide light in that direction, the structure including an active material (4) such that injecting opposite-type carriers into the material causes gain to appear so as to amplify laser light guided by the structure, the gain and the refractive index of the material depending on the concentrations of such carriers;
two end faces (8, 10) forming two ends of said waveguide structure and presenting reflectances so as to co-operate with the structure to constitute a resonant cavity for said laser light, the cavity having an optical length that is dependent on said refractive index of said active material, the cavity having a succession of resonant frequencies that are inversely proportional to the optical length, said reflectance of at least one of said end faces (8) being limited so as to enable said laser light (12) to be emitted from the cavity; and
doped layers (14, 16) situated on either side of said active material (4) and suitable for supplying said opposite-type carriers;
said source further including:
electrodes (18, 19) situated on said chip (2) to enable a powering current (JA) to be passed therethrough, thereby causing said injection of opposite-type carriers from said doped layers, so as to cause said laser light to grow in and to be emitted from said cavity at one of said resonant frequencies of the cavity;
a power supply (20. 22) supplying said powering current (JA) to the electrodes and imposing variations on the current to form current pulses (24) enabling said gain to be switched so that said laser light (12) is emitted by said chip in the form of raw light pulses (26) having an initial duration (28), so that varying said powering current (JA) in each of said current pulses causes a variation in the optical length of said cavity during each of said raw light pulses. the variation in the optical length being an absolute variation and being accompanied by a relative variation constituted by the ratio of the absolute variation divided by the optical length, the variations in optical length causing an absolute variation in the frequency of said laser light and imparting an initial spectrum width to the light pulse, a relative variation in the frequency being constituted by the ratio of the absolute variation divided by the frequency, and being equal to said relative variation in optical length; and
a dispersive line (30) suitable for guiding said laser light and applying a delay thereto dependent on the frequency thereof, the line having an input (32) for receiving said raw light pulses (26) and an output (34) for responding by supplying compressed light pulses (36) having a corrected duration (38) that is less than said initial duration;
said source being characterized by the fact that, successively and in said longitudinal direction, said chip (2) not only has a gain segment (40) in which said waveguide structure (4, 6) includes said active material (4) and receives said injection of carriers caused by said powering current so that varying the current causes an interfering variation in the refractive index of the material, but also at least one additional segment (42, 44) in which the waveguide structure is organized such that no significant variation in refractive index is caused by said variation in the powering current in the same direction as said interfering variation in refractive index, whereby the optical length of said cavity is increased and this increase causes a decrease in said relative variation in the optical length, a decrease in said relative variation in the frequency of said laser light, a decrease in said absolute variation in this frequency, and a decrease in said spectrum width.

3. A source according to claim 2, said waveguide structure including:
an active strip (4) limited to said gain segment (40) and constituted by said active material, the material having a refractive index that is greater than those of the surrounding materials; and
a passive waveguide (6) extending at least through said additional segment (42, 44), the passive waveguide being made of a material having a refractive index that is greater than those of the surrounding materials.

4. A source according to claim 3, characterized by the fact that one of said additional segments constitutes a diffraction grating segment (44) in which said passive waveguide (6) presents a periodic succession of variations in its cross-sectional dimensions, the succession constituting a Bragg reflector (7) suitable for selecting one of said resonant frequencies of said optical cavity to constitute the frequency of said laser light (12).

5. A source according to claim 4, characterized by the fact that a top face (3) of said chip (2) carries firstly one of said electrodes constituting a gain electrode (18) located in said gain segment (40) and powered by said power supply (20, 22), and secondly a frequency adjustment electrode (17) located in said frequency adjustment segment (44) and connected to a frequency adjustment generator (23) of said source to pass a frequency adjustment current (JB) through said passive waveguide (6), thereby causing opposite-type charge carriers to be injected into said waveguide material, so as to control the refractive index of the material and the resonant frequency selected by said Bragg reflector (7).

6. A source according to claim 4, characterized by the fact that said chip (2) further includes a passive segment (42) constituting one of said additional segments.

7. A source according to claim 3, said chip (2) being constituted by a binary material outside of said active strip (4) and of said passive waveguide (6), the material being n-type doped in a layer (16) extending beneath said waveguide structure (4, 6), and being p-type doped in a layer (14) extending above the waveguide structure, said active material and said waveguide material being ternary or quaternary and having energy forbidden bands that are of different widths.

8. A soliton optical transmission system including:
a semiconductor light pulse source for supplying light pulses (36) on command;
an input circuit (60) receiving data to be transmitted and controlling a power supply (20. 22) for the source so as to make the source supply a succession of light pulses, in which succession the time intervals between the pulses are representative of the data to be transmitted;
a line fiber (62) constituted by a very long optical fiber receiving said succession of light pulses, and presenting chromatic dispersion and a Kerr effect such that the dispersion and the Kerr effect compensate each other to retain the shape of a light pulse when the pulse presents intensity, duration and spectrum width that are characteristic of a soliton of the fiber; and
a receiver (64) receiving the light pulses transmitted by said line fiber and processing the received pulses so as to restore said data to be transmitted;
the system being characterized by the fact that said light pulse source is a source according to any one of claims 1, 2, 5, and 7, such that it supplies said light pulses in the form of said solitons of said line fiber (62).
